# EUROPÄISCHE PATENTSCHRIFT

(11) **EP 2 018 653 B1**
(45) Veröffentlichungstag und Bekanntmachung des Hinweises auf die Patenterteilung: **06.08.2014**
(21) Anmeldenummer: 07728997.3
(22) Anmeldetag: 10.05.2007
(51) Int. Cl.: H01J 37/32, C23C 14/32, C23C 14/56

(54) **ARCQUELLE UND MAGNETANORDNUNG**
ARC SOURCE AND MAGNET ARRANGEMENT
SOURCE D'ARC ET ARRANGEMENT D'AIMANTS

(30) Priorität: 16.05.2006 CH 792062006
(43) Veröffentlichungstag der Anmeldung: 28.01.2009
(60) Teilanmeldung: 12158542.6
(73) Patentinhaber: Oerlikon Trading AG, Trübbach, 9477 Trübbach (CH)
(72) Erfinder: KRASSNITZER, Siegfried, A-6800 Feldkirch (AT); HAGMANN, Juerg, CH-9468 Sax (CH); GWEHENBERGER, Juergen, A-6832 Dafins (AT)
(74) Vertreter: Troesch Scheidegger Werner AG
(86) Internationale Anmeldenummer: PCT/EP2007/054545
(87) Internationale Veröffentlichungsnummer: WO 2007/131944

(56) Entgegenhaltungen:
- EP-A- 0 899 773
- WO-A1-00/16373
- DE-A1- 4 329 155
- DE-A1- 10 250 941
- GB-A- 2 331 768
- US-A- 4 448 653
- US-A- 4 673 477
- US-A- 5 262 028

## Beschreibung

### Technisches Gebiet

Die Erfindung betrifft eine Arcquelle gemäss dem Oberbegriff des Anspruchs 1 und ein Herstellungsverfahren nach Anspruch 21. Bevorzugte Ausführungen der Erfindung werden in den Unteransprüchen 2 bis 20 offengelegt.

### Stand der Technik

Prinzipiell funktioniert das Funkenverdampferverfahren auch ohne Magnetfeld. Der elektrische Funken, auch Arc oder, am Substrat, Arc Spot genannt, läuft dabei nach einem Zufallsmuster (Random-Arc) über das Target, die Targetausnutzung ist dabei für einige insbesondere nur aus einer Komponente bestehende Targetmaterialien wie beispielsweise Titan bereits zufriedenstellend. Bei Betrieb im Random Verfahren ohne Führung durch ein äusseres Magnetfeld ist jedoch die Arc-Spot Bewegung sehr langsam und die Emission von Makropartikeln, sogenannter Droplets, sowohl bezüglich der Anzahl als auch bezüglich der Grösse für die meisten Beschichtungen nicht akzeptabel.

Zur Lösung dieses Problems wurden sehr unterschiedliche Verfahren Vorgeschlagen. So wurde erkannt, dass bei zunehmendem parallel zur Vorderfläche verlaufendem Magnetfeld die Droppletdichte abnimmt, während bei senkrechten zur Targetvorderfläche orientierten Feldlinien tendentiell grössere Makropartikel emittiert werden. Allerdings ist die mit bis jetzt bekannten Magnetfeldern erreichbare Targetausnützung oftmals sehr schlecht. Ein weiteres Problem bei diesen Magnetfeldern ist, dass die Erzeugung von parallelen Feldern nicht gleichmässig genug über die ganze Targetvorderfläche erfolgen kann.

Eine andere Möglichkeit ist das in US 4,673,477 beschriebene sogenannte steered arc Verfahren. Dabei wird durch bewegte, mehr oder weniger parallel zum Target liegende Magnetfelder der senkrecht zur Targetvorderfläche einfallende Arc-Spot seitlich abgelenkt und ein magnetischer Pfad (Racetrack) ähnlich wie beim Sputter Verfahren erzeugt. Durch die Rotation einer Magnetanordnung hinter dem Target kann der Funke stark beschleunigt über die Targetoberfläche geführt und dadurch die Erosion günstig beeinflusst werden. Jedoch gilt auch hier, dass es auf dem Target Bereiche gibt, welche keine parallelen Magnetfeldkomponenten haben und damit die günstige Eigenschaft des sehr schnell bewegten Arc-Spot im Racetrack zunichte machen. Ausserdem ist dieser Aufbau durch Verwendung des drehenden Magnetsystems relativ teuer und auf bestimmte Targetgeometrien beschränkt.

Ein weiteres Verfahren zur Erzielung von Makropartikel armen Schichten ist die u.a. in US 6,663,755 beschriebene "filtered arc" Technik. Dabei ist jedoch der apparative Aufwand bei gleichzeitig stark verringerter Abscheiderate sehr hoch.

Eine Methode parallele Magnetfelder über einen Grossteil der Targetoberfläche zu erzeugen, wird in US 5,861,088 bzw. DE 43 29 155 beschrieben. Hier wird durch Verwendung von zwei axial ausgerichteten Spulen, von denen zumindest eine hinter dem Target angebracht ist, und einem Permanent-Magnetkern ein Feldverlauf erzeugt welcher innerhalb eines konzentrischen Bereichs (Racetrack) vorwiegend parallele Magnetfeldlinien auf der Targetvorderfläche generiert. Die Targeterosion kann durch eine geeignete Aufteilung des Stroms auf die Spulen gesteuert werden. Um den problematischen Zentralbereich des Targets, bei dem die Feldlinien senkrecht zur Targetvorderfläche stehen möglichst klein zu halten wird eine Anordnung des Permanent-Magnetkern in einer in der Rückseite des Targets eingebrachten Ausnehmung vorgeschlagen, was die mechanische Stabilität des Targets beeinflusst und einen weiteren Bearbeitungsschritt beim Herstellen des Targets erfordert. Ein weiterer Nachteil dieser Methode ist, wie der Erfinder selbst in der Folgeanmeldung US2004/0154919 erwähnt, dass sich die Feldstärke mit der Erosion des Targets ändert, und dies nur schwer mit den Spulen auszugleichen ist, was eine nichtoptimale Targetausnutzung zur Folge hat.

Alternativ wird in US2004/0154919 vorgeschlagen zur Verbesserung der Feldführung zumindest ein weichmagnetisches Eisenjoch zwischen den Spulen zu verwenden. Damit kann der Scheitelpunkt des Feldlinienbogens zu kleineren Durchmessern verschoben werden. Auch hier können Bereiche paralleler Feldlinien lediglich auf der Oberfläche verschoben, nicht aber gleichzeitig auf dem Grossteil der Targetoberfläche konstant gehalten werden. Damit bewegen sich insbesondere bei Materialien, die zu einer starken Teilung der Arc-Fusspunkte (Arc-Spots) neigen (wie z.B. A1, AlCr, AlTi, AlSi, AlCrSi, TiSi, AlTiSi, ...), auch hier die Arc-Spots mit stark unterschiedlichen Geschwindigkeiten über die Targetoberfläche.

Ein gänzlich unterschiedlicher Ansatz wird in US 6,334,405 mit einer Feldlinenführung, welche im Wesentlichen senkrecht zur Targetvorderfläche ist, vorgeschlagen. Dabei ist die Felderzeugende Spule oder ein Magnetring auf gleicher Höhe oder vor der Targetvorderfläche angeordnet. Gleichzeitig werden gegenüber den oben erwähnten Verfahren deutlich stärkere Magnetfelder verwendet. Angeblich läuft dadurch der Funken (Arc) auf dem Target besser verteilt, d.h. die Anzahl der Arc-Spots wird erhöht und somit die Energie pro Spot erniedrigt (Footpoint Splitting) und damit kleinere Makropartikel emittiert.

Aus der DE 102 50 941 ist eine Universalquelle bekannt, welche, umschaltbar, als Sputterquelle, insbesondere Magnetronsputterquelle und als Arcquelle eingesetzt wird. Zur Berücksichtigung der Unterschiede von Sputterquelle und Arcquelle wird ein auswechselbares Magnetsystem vorgesehen und der die jeweilige Plasmaentladung speisende Generator ausgewechselt oder umgeschaltet. Für den Betrieb dieser Universalquelle als Arcquelle muss eine Zündvorrichtung für den Arc, auch kathodische Lichtbogenentladung genannt, vorgesehen sein und ein Niederspannungs-Hochstromgenerator, welcher in der Lage ist, den für den Unterhalt des oder der Arcs notwendigen hohen Strom von 40 - 250 A im Betrieb zu liefern, bei einer tiefen Entladungsspannung (Bogenspannung) von 10 - 100 V.

Die Druckschrift US 4448653 zeigt eine Magnetanordnung für eine Sputterquelle.

Als Sputterquelle werden Sputterspannungen von 50 - 1000 V eingesetzt, entsprechend einer Sputterleistung von 0,5 - 10 kW, was Entladeströme in der Grössenordnung von 10 A ergibt.

Aus der WO 00/16373 ist eine Arcquelle bekannt mit einer Magnetanordung, wie sie im Zusammenhang mit Fig. 1, 2 und auch 8 diskutiert werden wird.

Dabei sind entlang des Randbereiches des Targets sowie um dessen Zentrumsbereich, zur Targetvorderfläche senkrechte magnetische Dipole vorgesehen mit zur Targetoberfläche parallelen Polflächen, aus welchen das magnetische Feld mit seinen Feldlinien, senkrecht zur Targetvorderfläche, austritt bzw. wieder eintritt.

Aus der US 5 298 136 ist ebenfalls die Realisierung eines Feldverlaufes über der Targetoberfläche einer Arcquelle wie im Zusammenhang mit der WO 00/16373 beschrieben vorbekannt. Diesem Feld werden zusätzliche Magnetfelder dynamisch überlagert.

Die Druckschrift GB 2 331 768 zeigt eine Arcquelle, die einen Magnetkreis mit Magneten und Polstücken aufweist, der ein Magnetfeld erzeugt, dessen Feldlinien im wesentlichen parallel zur Targetvorderfläche verlaufen.

### Definitionen

- Die technische Bezeichnung "Arcquelle" steht im Folgenden synonym für den älteren aber umständlichen deutschen Begriff Funkenverdampferquelle. Es handelt sich dabei um eine PVD-Quelle, bei der von einem Target durch zumindest einen, meist aber mehrere, mittels einer Hochstromentladung erzeugte Arcs oder kathodische Lichbogenentladungen, auch Funken genannt, Material in hochionisiertem Zustand verdampft wird.
- Wie aus der DE 102 50 941 beispielsweise vorbekannt, hat eine Arcquelle eine Zündeinrichtung für den Arc. Die Arcentladung wird mittels eines Niederspannungs/Hochstromgenerators im Betrieb gespiesen, welcher in der Lage ist, bei einer tiefen Spannung von 10 - 100 V einen Bogenstrom von 40 - 250 A oder gar höher zu liefern.
- Unter einem "axial" gepolten Magnetsystem wird ein Magnetsystem verstanden, welches im Wesentlichen senkrecht zur Vorderfläche des Targets einer Arcquelle gepolt ist und dessen magnetische Dipole mithin im Wesentlichen senkrecht zur genannten Oberfläche stehen. Die Aus-/Eintrittsflächen für das magnetische Feld, die dem Target zugewandt sind, sind dabei im Wesentlichen parallel zur Targetvorderfläche.
- Unter "axialen" Komponenten des Magnetfeldes verstehen wir Komponenten, die senkrecht zur Targetvorderfläche stehen oder, bei nicht planen Targetvorderflächen, senkrecht zur Tangentialebene an die Targetvorderfläche, an dem dem bezüglich Magnetfeld betrachteten Raumpunkt nächstgelegenen Vorderflächenpunkt.
- Unter einem "radial" gepolten Magnetsystem verstehen wir ein Magnetsystem, welches im Wesentlichen parallel zur Targetvorderfläche einer Arcquelle gepolt ist. Damit liegen die magnetischen Dipole dieses Magnetsystems im Wesentlichen parallel zur Targetvorderfläche und es sind dessen Polaustrittsflächen, aus denen das Magnetfeld senkrecht aus- bzw. eintritt, im Wesentlichen senkrecht zur genannten Targetvorderfläche.
- Unter "radialen" Komponenten des Magnetfeldes verstehen wir Komponenten, die parallel zur Targetvorderfläche stehen oder, bei nicht planen Targetvorderflächen, parallel zur Tangentialebene an die Targetvorderfläche an dem dem bezüglich Magnetfeld betrachteten Raumpunkt nächstgelegenen Vorderflächenpunkt.
- Der zentrale Targetbereich ist definiert durch eine Linie, die um den Flächenschwerpunkt der Targetvorderfläche umläuft und mindestens überwiegend dem geometrischen Ort folgt, der durch die halben Strahlen vom genannten Schwerpunkt zum Targetrand festgelegt ist. Der Targetrandbereich schliesst an den zentralen Targetbereich nach aussen an.
- Wenn wir vorangehend und nachfolgend von der Targetvorderfläche sprechen, im Zusammenhang mit diesbezüglichen Parallelitäts- und Senkrecht-Relationen von Magnetpolungen, von magnetischen Dipol-Richtungen, von Magnetfeldkomponenten, so verstehen wir unter dieser Fläche die durch Arcverdampfen zu erodierende Oberfläche des Targets in ihrem Neuzustand. Wenn diese Vorderfläche in ihrem Neuzustand bereits profiliert, z.B. gestuft, ist, so wird in diesem Fall eine Anschmieg-Fläche an die Targetvorderfläche verstanden.
- Der Ort, an dem die Feldkomponenten Bᵣ, die parallel - radial - zur Targetvorderfläche sind, den gleichen absoluten Betrag wie die dazu senkrechten - axialen - Feldkomponenten B_{z} aufweisen wird 45° Ort genannt, da hier die magnetischen Feldlinien in einem Winkel von 45° in die bzw. aus der Targetvorderfläche treten.
- Wenn wir von magnetischen Dipolen sprechen, an einem Magnetsystem, welche " mindestens überwiegend" eine bestimmte Richtung haben, so verstehen wir damit, dass
   a)die angesprochenen Dipolvektoren eine Komponente haben, in der erwähnten Richtung, die grösser ist als diejenige in der andern Richtung und zwar betrachtet in einer Ebene, die senkrecht zur Targetvorderfläche steht und durch deren Flächenschwerpunkt verläuft,
   b) am Magnetsystem auch anders gerichtete Dipole vorhanden sein können, aber, gesammtwirkungsmässig, von untergeordneter Bedeutung auf das resultierende Magnetfeld sind.

### Darstellung der Erfindung

Die Erfindung betrifft eine Arcquelle gemäß Anspruch 1.

Es ergibt sich eine bessere Ausnützung des Targets sowie eine Herabsetzung der Spritzerbildung.

Mit einer solchen Magentanordnung kann in einer Ausführungsform der erwähnte Bereich gar zumindest 90% der Targetvorderfläche betragen.

Die parallelen Feldkomponente betragen im angesprochenen Bereich in einer Ausführungsform 20 bis 60, bevorzugt 40 bis 50 Gauss (jeweils beide Grenzen eingeschlossen).

Eine weitere Reduktion der Spritzerbildung erfolgt in einer Ausführungsform dadurch, dass im zentralen Targetbereich eine von der Kathode elektrisch isolierte Abdeckung angebracht ist. Sofern ein inneres Magnetsystem vorhanden ist, wird, in einer Ausführungsform, mit dieser Abdeckung der Bereich mindestens nahezu bis zum -an der Targetvorderfläche von innen nach aussen fortschreiten- ersten 45°-Ort abgedeckt.

Damit kann auf einem derartig abgedeckten Target ein Festfressen des Funkens praktisch ausgeschlossen werden.

Eine solche Abdeckung kann aus einem weichmagnetischen Material, wie zum Beispiel Weicheisen und/oder aus einer hochtemperaturbeständigen magnetischen Legierung und/oder aus elektrisch isolierendem Material gefertigt sein. Ggf. kann diese Abdeckung mehrschichtig sein, mit Schichten von mindestens zwei der erwähnten Materialien. Bei Bedarf kann dabei die erwähnte Abdeckung zusätzlich gekühlt werden. Als isolierendes Abdeckungsmaterial eignet sich beispielsweise Al₂O₃ oder BN. Durch Einsatz elektrisch isolierenden Materials an der Abdeckung kann gleichzeitig die geforderte elektrische Isolierung der Abdeckung bezüglich des Targets realisiert werden, womit dann das zusätzliche Vorsehen von Isolatoren zwischen Abdeckung und Target entfallen kann.

Verschiedene Versuche haben weiter gezeigt, dass ein Ausbrechen des Funkens bzw. Arcs von der Targetvorderfläche auf die Oberfläche der Abdeckung durch eine zur Targetvorderfläche bündige oder gar leicht in die Targetvorderfläche eingesenkte Abdeckung wirkungsvoll verhindert werden kann. Die Einsenkung wird dabei in einer Ausführungsform und je nach Targetdicke zu 0,5mm - 6 mm gewählt.

Sofern, wie in den meisten Fällen bevorzugt, rückseitig des Targets eine Kühlplatte, beispielsweise mit Kühlwasserkreislauf, vorhanden ist, so wird mindestens eines der Magnetsysteme, insbesondere das innere, in einer Ausführungsform, an bzw. im.Target und/oder der Kühlplatte, beispielsweise in einem Kühlwasserkreislauf oder an der dem Target abgewandten Kühlplattenrückseite angebracht. Gemäss einer Ausführungsform ist das oder das mindestens eine Magnetsystem mindestens teilweise in einer Ausnehmung an der Targetrückseite angebracht werden. Die durch diese Ausnehmung bewirkte Reduktion der Targetdicke ergibt z.B. den Vorteil, dass schwächere Magnete am inneren Magnetsystem verwendet werden können, um die erwünschte Wirkung auf der Targetvorderfläche zu erzielen.

Wird die Targetausnehmung, worin mindestens teilweise das innere Magnetsystem angebracht ist, durchgängig, bis an die Vorderseite des Targets ausgeführt, verläuft somit durch das Target hindurch, was aus produktionstechnischen Gründen einfacher sein kann und zusätzlich Einsparungen beim teuren Targetmaterial ermöglicht, wird, in einer Ausführungsform, eine wie oben beschriebene Abdeckung vorgesehen, um ein Überhitzen der Magnete des inneren Magnetsystem zu verhindern. Zusätzliche Massnahmen zur Magnetkühlung und Abdichtung der Vakuumseite gegen Atmosphäre und/oder Flüssigkeit aus dem Kühlkreislauf sind dem Fachmann der Vakuum- bzw. Arcquellentechnik bekannt und werden daher nicht näher erläutert.

In einer weiteren Ausführungsform umfasst das Magnetsystem mit zur Targetvorderfläche mindestens überwiegend parallelen Dipolen Permanentmagnete, die in einer zur Targetvorderfläche im wesentlichen parallelen Ebene im wesentlichen gleichmässig verteilt entlang einer geschlossenen Schleife angeordnet sind, mit bezüglich der Schleife gleich gerichteten Dipolen.

Umfassen beide, d.h. das innere und das äussere Magnetsystem, derartig geschlossene Schleifen mit radial gepolten Magneten, d.h. magnetischen Dipolen im wesentlichen parallel zur Targetvorderfläche, so wird in einer Ausführungsform die Polung des inneren Magnetsystems gleich wie die Polung des äusseren Magnetsystem gewählt, d.h. die magnetischen Dipole an beiden geschlossenen Schleifen sind entweder vom zentralen Targetbereich nach aussen oder hin zum zentralen Targetbereich gerichtet. Damit haben sowohl das innere als auch das äussere Magnetsystem Süd- bzw. Nordpol gleichgerichtet, bezüglich der erwähnten Schleifen, innen- bzw. aussenliegend.

In einer weiteren Ausführungsform der erfindungsgemässen Arcquelle umfasst das oder das mindestens eine Magnetsystem eine Spule. Durch Vorsehen einer Spule an einem der Magnetsysteme kann die Einwirkung dieses Magnetsystems variabel gestaltet werden.

Dabei wird in einer weiteren Ausführungsform das äussere Magnetsystem so ausgebildet, dass es mindestens mit Teilen den Targetrand überragt.

Bei weiteren Ausführungsformen ist an der erfindungsgemässen Arcquelle lediglich das äussere Magnetsystem vorhanden, welches, mindestens überwiegend, Dipole parallel zu Targetvorderfläche umfasst, oder es ist lediglich das innere Magnetsystem vorhanden, welches, mindestens überwiegend, Dipole parallel zur erwähnten Targetvorderfläche umfasst. In einer weiteren Ausführungsform sind sowohl das äussere wie auch das innere Magnetsystem vorhanden, mindestens eines davon mit Dipolen mindestens überwiegend parallel zur, das andere mit Dipolen mindestens überwiegend senkrecht zur Targetvorderfläche, oder es sind in einer weiteren Ausführungsform mit beiden Magnetsystemen, an beiden Dipole mindestens überwiegend parallel zur Targetvorderfläche vorhanden, vorzugsweise, wie oben ausgeführt, radial gleichgerichtet.

Bei einer weiteren Ausführungsform sind wiederum äusseres und inneres Magnetsystem vorhanden und liegen im wesentlichen in einer Ebene.

So wird bei einer erfindungsgemässen Arcquelle, die ein äusseres und ein inneres Magnetsystem umfasst, das äussere Magnetsystem, insbesondere ein äusseres Magnetsystem mit zur Targetvorderfläche senkrechter Dipolausrichtung, wie mittels einer geschlossenen Schleife von Permanentmagneten realisiert, in einer Ebene mit dem vorgesehenen inneren Magnetsystem angeordnet. In diesem Fall steht einem inneren Magnetsystem mit mindestens überwiegend oder ausschliesslich zur Targetvorderfläche parallelen Dipolen ein äusseres gegenüber mit mindestens überwiegend oder ausschliesslich zur Targetvorderfläche senkrechter Dipolausrichtung. Es kann dabei ggf. auch das äussere Magnetsystem und/oder das innere sowohl magnetische Dipole aufweisen, die parallel zur Targetvorderfläche und Dipole, die senkrecht hierzu ausgerichtet sind. Bei einer weiteren Ausführungsform, bei welcher beide Magnetsysteme vorhanden sind, das äussere mindestens überwiegend magnetische Dipole, die senkrecht zur Targetvorderfläche ausgerichtet sind, aufweist, entlang einer geschlossenen Schleife, ist eine im wesentlichen entlang der Schleife umlaufende Spule vorgesehen, wie oben allgemein erläutert wurde.

Will man nämlich eine Arcquelle realisieren, die in bezug auf das Targetmaterial bzw. auf unterschiedliche Targetdicken besonders gut anpassbar ist, kann man als Teil des erwähnten äusseren und/oder ggf. inneren Magnetsystems eine Spule einsetzen. Diese bildet Teil des entsprechenden Magnetsystems, womit es möglich ist, durch Anlegen unterschiedlicher Spulenströme besonders den Verlauf bzw. die Grösse der Feldkomponenten B_{z} senkrecht zur Targetvorderfläche zu verschieben bzw. zu verändern.

Besteht das äussere Magnetsystem beispielsweise aus einer Spulenschleife und einer Permanentmagnetschleife mit parallelen und/oder senkrecht zur Targetvorderfläche gerichteten Dipolen, gebildet durch Permanentmagnete, so kann dieses äussere Magnetsystem mit den Permanentmagneten für den optimalen Betrieb mit Standardtargetmaterialien und/oder Standardtargetdicken ausgelegt sein. Für das Arcverdampfen anderer Materialien und/oder bei Verwendung von Nicht-Standardtargetdicken wird mit der Spule die optimale Gestalt des Magnetfeldes eingestellt.

In einer weiteren Ausführungsform wird dabei vorgeschlagen, dass das Target und das oder das mindestens eine der Magnetsysteme - hinter der Targetrückseite angeordnet - vakuumdicht voneinander getrennt sind. Dadurch wird es möglich, in einer weiteren Ausführungsform das oder das mindestens eine Magnetsystem als Teil einer Wechselmagnetanordnung auszubilden.

Damit ergibt sich die Möglichkeit, die Einsatzflexibilität der erfindungsgemässen Arcquelle zu erhöhen, indem das als Teil der Wechselmagnetanordnung ausgebildete Magnetsystem für unterschiedliche Quelleneinsätze leicht ausgewechselt werden kann. Dadurch, dass dabei das Target und das oder das mindestens eine Magnetsystem, welches Teil der Wechselmagnetanordnung ist, vakuumdicht voneinander getrennt sind, wird ermöglicht, das erwähnte Magnetsystem, im Einsatz, an Normalatmosphäre zu positionieren, womit die Wechselmagnetanordnung ohne Eingriff auf das Vakuumsystem und durch Vorsehen entsprechender, dem Fachmann bekannter Mittel, wie von Schnellverschlüssen, Führungsmitteln etc. leicht ausgetauscht werden kann.

Ein erfindungsgemässes Herstellungsverfahren arcbeschichteter Werkstücke ist in Anspruch 21 definiert.

### Beschreibung der Zeichnungen

Im Folgenden wird die Erfindung anhand von Figuren, welche verschiedene Ausführungsbeispiele darstellen, näher erläutert. Es zeigen
- Fig. 1: vereinfacht und schematisch, eine Arcquelle nach dem Stande der Technik mit innerem und äusserem Magnetsystem;
- Fig. 2: das mit einer Quelle gemäss Fig. 1 realisierte Magnetfeld an der Targetoberfläche, aufgeteilt in Komponenten parallel zur Targetvorderfläche (radiale Komponenten, Bᵣ) und Komponenten senkrecht zur Targetvorderfläche (axiale Komponenten, B_{z});
- Fig. 3: das mittels einer Quelle gemäss Fig. 1 realisierte Erosionsprofil am Target;
- Fig. 4: in einer Darstellung analog zu derjenigen von Fig. 1, eine Realisationsform einer erfindungsgemässen Arcquelle;
- Fig. 5: in einer Darstellung analog zu derjenigen von Fig. 2, das mittels der erfindungemässen Arcquelle nach Fig.4 realisierte Magnetfeld;
- Fig. 6: in einer Darstellung analog zu derjenigen von Fig. 3, das mittels der efindungsgemässen Arcquelle nach Fig. 4 realisierte Targeterosionsprofil;
- Fig. 7: die Körnung einer TiN-Beschichtungsoberfläche bei Beschichtung mittels einer erfindungsgemässen Arcquelle gemäss Fig. 4;
- Fig. 8: in Darstellung analog zu derjenigen von Fig. 7, die Beschichtungsoberflächenkörnung bei Beschichtung mit einer Arcquelle gemäss Stand der Technik von Fig. 1;
- Fig. 9: schematisch, in rückseitiger Aufsicht, ein kreisförmiges Target mit erfindungsgemäss vorgesehenem, inneren Magnetsystem im zentralen Targetbereich;
- Fig. 10: in einer Darstellung analog zu derjenigen von Fig. 9 , ein Rechtecktarget mit erfindungsgemäss vorgesehenem, inneren Magnetsystem im zentralen Targetbereich;
- Fig. 11: über der Targetvorderfläche das durch ein erfindungsgemäss eingesetztes Magnetsystem mit radialer Polung realisierte Magnetfeld;
- Fig. 12: in einer Darstellung analog zu derjenigen von Fig. 11 das Magnetfeld bei, gemäss Stand der Technik, axialer Polung eines Magnetsystems;
- Fig. 13: in einer schematischen, vereinfachten Darstellung, eine Ausführungsform einer erfindungsgemässen Arcquelle bzw. einer Magnetanordnung an der Arcquelle;
- Fig. 14: in einer Darstellung analog zu derjenigen von Fig. 13, eine weitere Ausführungsform;
- Fig. 15: bezüglich eines Targets drei weitere Ausführungsformen von Magnetanordnungen an einer erfindungsgemässen Arcquelle;
- Fig. 16: an erfindungsgemäss eingesetzten, radial gepolten Magneten, eine weitere Optimierungsgrösse, nämlich Polflächenausrichtung;
- Fig. 17: in Darstellung analog zu derjenigen von Fig. 5, den Variationsbereich der axialen Feldkomponente, wie mit einer gemäss Fig. 4 am äusseren Magnetsystem vorgesehenen, steuerbaren Spulenanordnung realisiert;
- Fig. 18 und 19: mittels gemäss Fig. 17 variabel optimiertem Magnetfeld realisierte, optimierte Targeterosionsprofile;
- Fig. 20: schematisch und vereinfacht, eine weitere Ausführungsform einer erfindungsgemässen Arcquelle;
- Fig. 21 und 22: Weitere Ausführungsformen der in Fig. 20 dargestellten Arcquelle;
- Fig. 23: wiederum vereinfacht und schematisch, die Anordnung des oder mindestens eines der erfindungsgemäss vorgesehenen Magnetsysteme rückseitig des Targets;
- Fig. 24 und 25: Weitere Ausführungsformen der Anordnung gemäss Fig. 23;
- Fig. 26: schematisch und vereinfacht, Vorkehrungen, um die erfindungsgemäss vorgesehene Magnetsystemanordnung von ausserhalb eines Vakuumrezipienten und ohne Vakuumbeeinträchtigung zugreifbar zu machen, und
- Fig. 27: vereinfacht und schematisch, eine als Wechselmagneteinrichtung ausgebildete Magnetsystemanordnung.

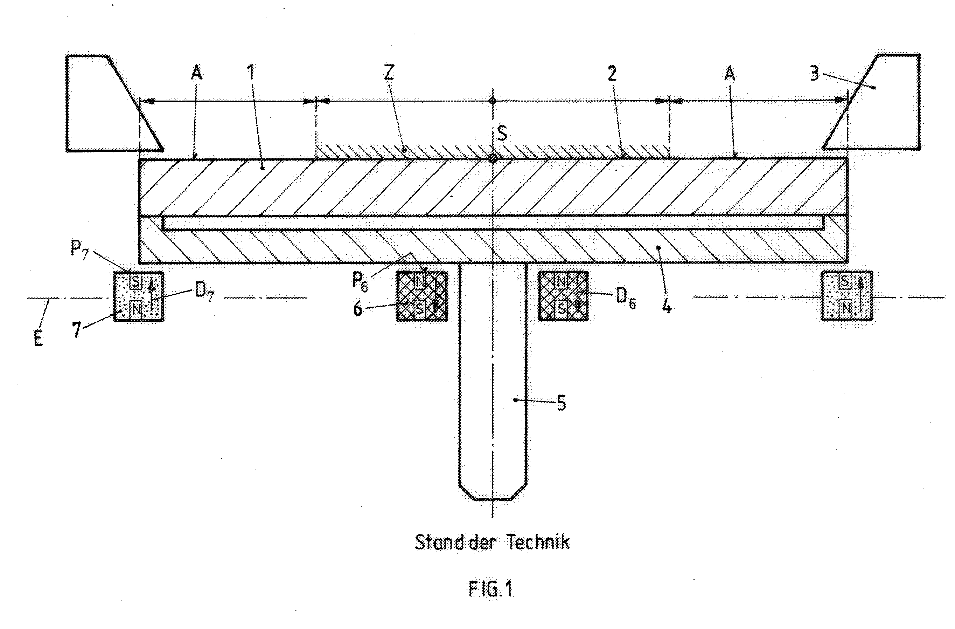

Fig.1 zeigt einen schematischen Querschnitt durch eine Arcquelle wie sie aus dem Stand der Technik bekannt ist. Um die Targetvorderfläche 2 eines auf einer Kühlplatte 4 montierten Targets 1 ist ein umlaufender Konfinementring 3 zur Begrenzung des Funkens auf der Targetvorderfläche angeordnet. Eine üblicherweise ebenfalls umlaufende Gegenelektrode, meist eine Anode, ist hier nicht dargestellt. Im zentralen rückwärtigen Bereich des Targets befindet sich eine Stromzuführung 5, die eine hier nicht dargestellte Kühlwasserzu- und Ableitungen umfassen kann.
Wie bereits eingangs erwähnt, ist der zentrale Targetbereich definiert als Bereich Z mit dem Flächenschwerpunkt S der Targetvorderfläche 2 und ist mindestens überwiegend berandet durch einen geometrischen Ort, der sich durch Teilung der Verbindungsstrahlen vom Schwerpunkt S an den Rand der Targetvorderfläche ergibt.
Ebenfalls im zentralen rückwärtigen Bereich befindet sich ein inneres Magnetsystem 6 realisiert als Permanentmagnetring. Im äusseren Bereich A des Targets 1 ist ein äusseres Magnetsystem 7, realisiert als Permanentmagnetring angeordnet. Beide Magnetsysteme sind axial gegenpolig magnetisiert mit Dipolen D₆ bzw. D₇ senkrecht zur Targetvorderfläche 2, so dass ein Teil der Feldlinien, die von der Polfläche P₇ des äusseren Systems 7 austreten in der Polfläche P₆ des inneren 6 wieder eintreten, während der Feldlinienvelauf auf der Rückseite der Magnetsysteme, mit Bezug auf die Ringebene E, im wesentlichen spiegelbildlich ist.

Die massgeblichen Polflächen P₇ und P₆ sind parallel zur Targetvorderfläche 2, und es treten an diesen Flächen die Magnetfeldlinien jedenfalls senkrecht aus.

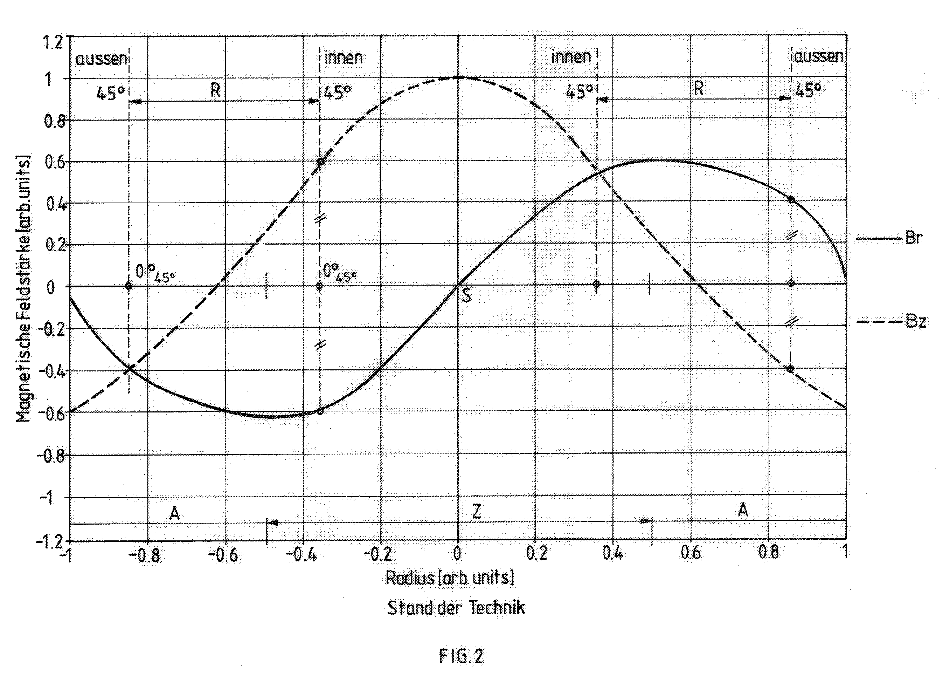

Den durch eine solche Anordnung erzeugten Feldlinienverlauf an der Targetvorderfläche, aufgeteilt in eine radiale Komponente Bᵣ, parallel zur Targetvorderfläche, und eine axiale Komponente B_{z}, senkrecht zur Targetvorderfläche 2, zeigt Fig. 2. Dabei ist am äusseren Targetbereich A bzw. im zentralen Bereich Z des Targets ein verhältnismässig geringer Anstieg bzw. Abfall der absoluten Grösse der radialen Feldkomponente Bᵣ zu erkennen, während die axiale Feldkomponente B_{Z} grossteils quasilinear gegen das Targetzentrum S(O-Punkt der Abszisse) ansteigt. Dadurch sind die, durch die Endpunkte der Pfeile R bezeichneten 45°-Orte O_{45°} auf der Targetoberfläche relativ weit gegen das Zentrum des Targets hin gelegen. Der Flächenbereich R mit Beträgen Br grösser als Bz ist dadurch verhältnismässig klein.

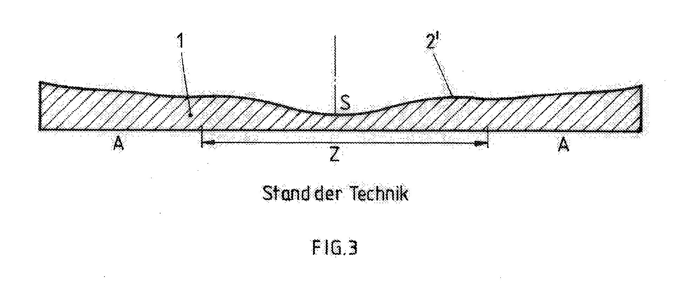

Aufgrund der im Innern des zentralen Targetbereichs Z sehr kleinen radialen Komponenten Bᵣ bewegt sich der Lichtbogenfusspunkt dort langsam, die Aufenthaltswahrscheinlichkeit des Funkens ist in diesem Bereich verhältnismässig hoch, was zu einem verstärkten Abtrag von Targetmaterial und einem wie in Fig. 3 gezeigten Erosionsprofil 2' mit einer schlechten Targetausnutzung führt. Das Target muss in diesem Fall allein wegen der tiefen Erosion im zentralen Targetbereich Z gewechselt werden. Bleibt der Funken durch die geringe radiale Ablenkung stehen und brennt, wenn auch nur kurz, stationär auf derselben Stelle des Targets so kommt es zu einer Überhitzung und in der Folge zu explosionsartigen Verdampfungserscheinungen auf der Targetvorderfläche mit allen nachteiligen Folgen, wie überproportionalem Materialabtrag und Tröpfchenbildung bzw. -abscheidung auf dem Beschichtungsgut.

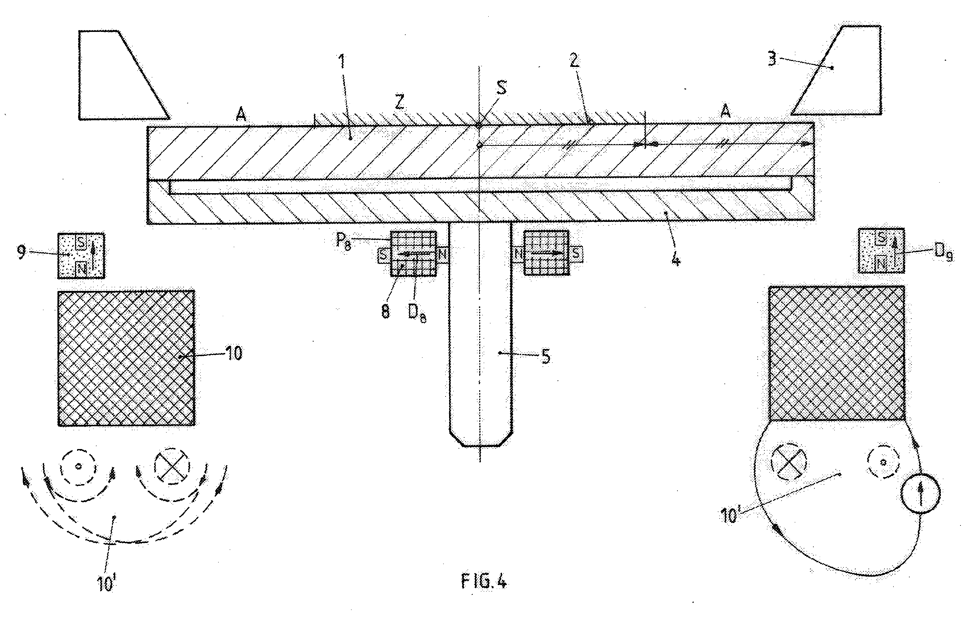

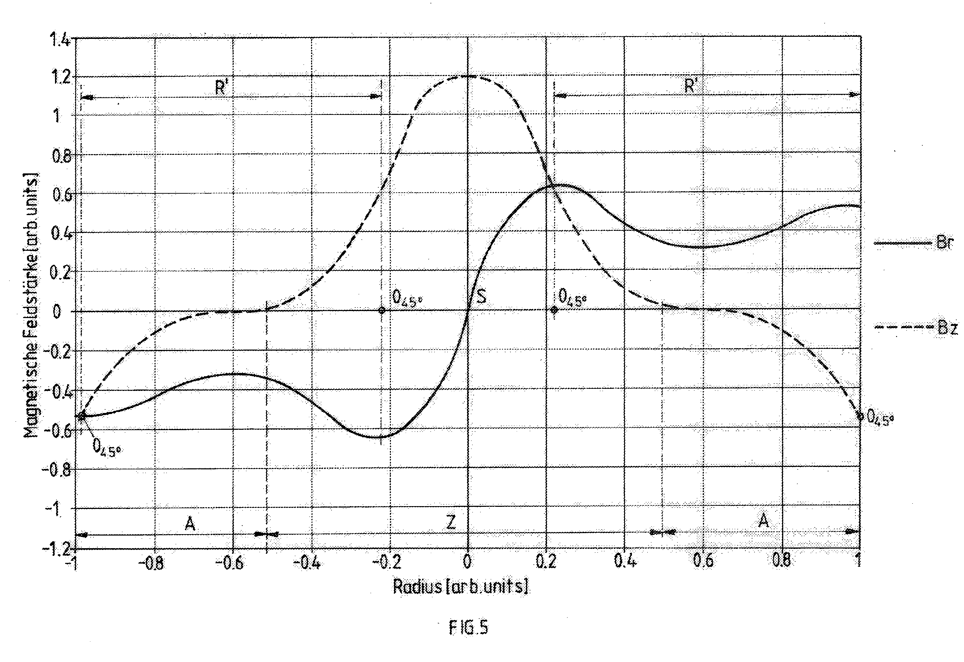

Fig. 4 zeigt eine Arcquelle gleicher Einbaugeometrie aber in einer erfindungsgemässen Ausführungsform. Auch hier umfasst die Magnetanordnung ein inneres 8 und ein äusseres Magnetsystem 9, 10, jedoch ist in diesem Fall der innere Magnetring bzw. eine innere geschlossene Magnetschleife mindestens überwiegend radial gepolt, womit die Dipole D₈ mindestens überwiegend parallel zur Targetvorderfläche 2 gerichtet sind. Der Magnetring des äusseren Systems 9, 10 ist weiterhin mindestens überwiegend axial gepolt, womit die Dipole D₉ mindestens überwiegend senkrecht zur Targetvorderfläche 2 stehen. Dabei sind die Polflächen P₈ des inneren Magnetsystems 8 mindestens überwiegend senkrecht zur Targetvorderfläche 2 ausgerichtet. Mit einer solchen Magnetsystem-Anordnung wird ein wie in Fig. 5 beispielhaft dargestelltes Magnetfeld erzeugt. Die durch die Endpunkte der Pfeile R' markierten 45° Orte O_{45°} auf der Targetvorderfläche sind dabei deutlich näher zum Targetrand (äusserer Ort O_{45°}) bzw. zur Targetmitte (innerer Ort O_{45°}) verschoben, womit der Flächenbereich R' wesentlich grösser ist als der Flächenbereich R aus Fig. 2.

Während nämlich bei angenommener kreisplattenförmiger Targetvorderfläche, sich gemäss Fig. 2 ein solcher Bereich zu 58 % der Targetvorderfläche ergibt, an welcher der Betrag von Bᵣ grösser ist als der Betrag von B_{Z}, ist dieser Bereich bei erfindungsgemässer Arcquelle und Resultat nach Fig. 5, 96 %.

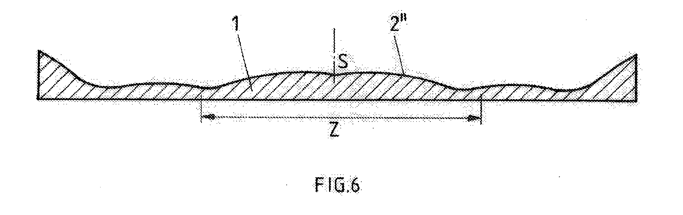

Fig. 6 zeigt ein durch eine solche erfindungsgemässe Arcquelle erzeugtes Abtragsprofil. Im zentralen Bereich Z des Targets ist der Bereich kleiner radialer- Bᵣ-und grosser axialer- B_{Z}- Feldkomponenten sehr klein, damit bewegt sich der Fusspunkt der Funkenentladung mit verhältnismässig hoher Geschwindigkeit gegen bzw. durch diden zentralen Bereich Z wodurch ein übermässiger Abtrag bis hin zum Targetzentrum wirkungsvoll verhindert wird. Daher ist in der Targetmitte nur ein sehr schwach ausgeprägtes Abtragmaximum erkennbar. Der Funken verweilt bei einer solchen Magnetanordnung am längsten im Bereich mit hoher Radialkomponente Br, also dort wo der Funken hohe tangentiale Ablenkung erfährt und bewirkt dort auch den verhältnismässig grössten Abtrag. Mit einem solchen Magnetfeld kann das Targetmaterial bis knapp an den Rand ziemlich gleichmässig abgetragen werden. Vorteilhaft wird dabei das äussere Magnetsystem 9, realisiert mit einem Magnetring bzw. entlang einer geschlossenen Schleife, mit einem Durchmesser, der gleich oder etwas grösser ist als der Targetdurchmesser, ausgeführt.

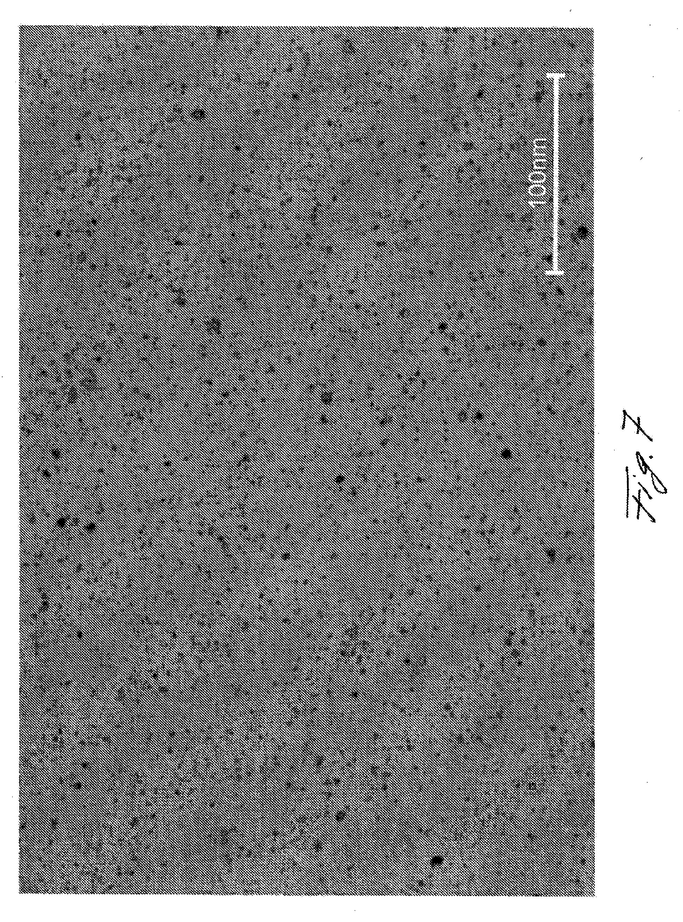

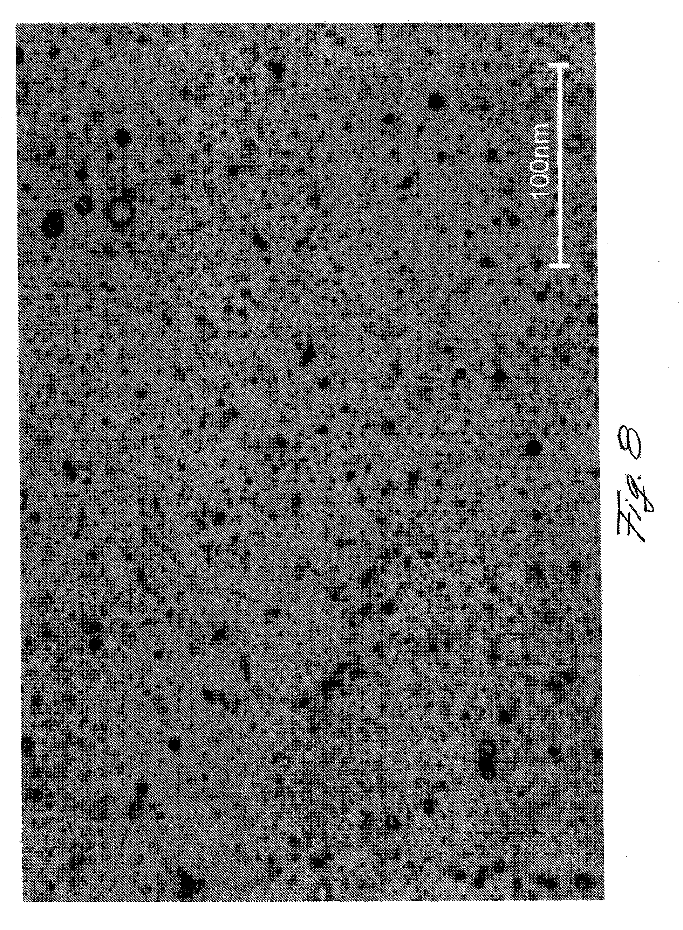

Es wird somit erfindungsgemäss eine wesentlich bessere Ausnutzung des oftmals teuren Targetmaterials erreicht und gleichzeitig die Schichteigenschaften verbessert. So zeigt die mit einer erfindungsgemässen Arcquelle in Fig. 7, unter sonst gleichen Bedingungen wie die in Fig. 8 mit einem herkömmlichen Magnetsystem hergestellte TiN-Schicht, eine wesentlich glattere Oberfläche: Die Durchschnittsgrösse der Droplets ist erfindungsgemäss wesentlich verringert.

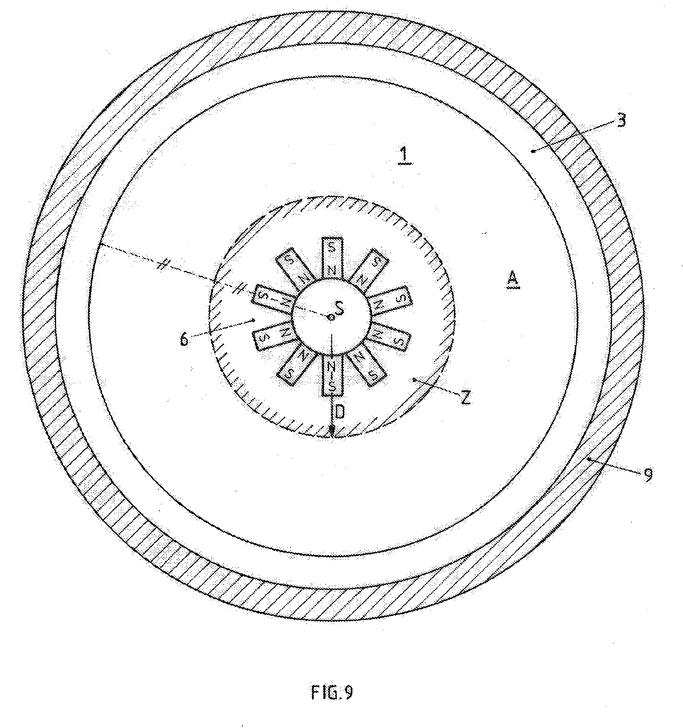

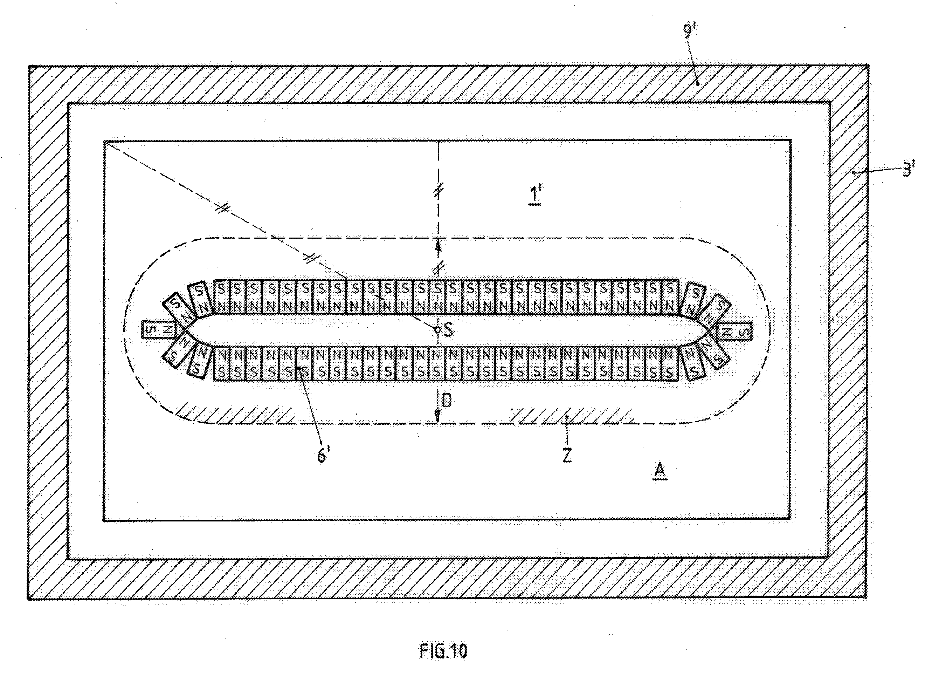

In Fig. 9 ist, beispielhaft, in Aufsicht auf die Targetrückseite, der prinzipielle Aufbau einer runden Arcquelle, in Fig. 10 der einer rechteckigen Arcquelle gezeigt, jeweils mit einem inneren axial gepolten Magnetsystem 6, 6' entlang einer geschlossenen Schleife. Die Schleifen sind durch Einzelmagnete aufgespannt, die jeweils mit identischer Polaritätsrichtung D nach innen bzw. aussen gerichtet angeordnet sind.

Wiewohl eine erfindungsgemässe Arcquelle prinzipiell mit nur einem radial gepolten Magnetsystem betrieben werden kann, ist eine wie grundsätzlich in Fig. 4 gezeigte Anordnung mit zumindest einem zusätzlichen axial gepolten Magnetsystem für viele Targetmaterialien vorteilhaft. Vorteilhafte Wirkungen können auch durch die Kombination von zumindest zwei radial gepolten Magnetsystemen erreicht werden.

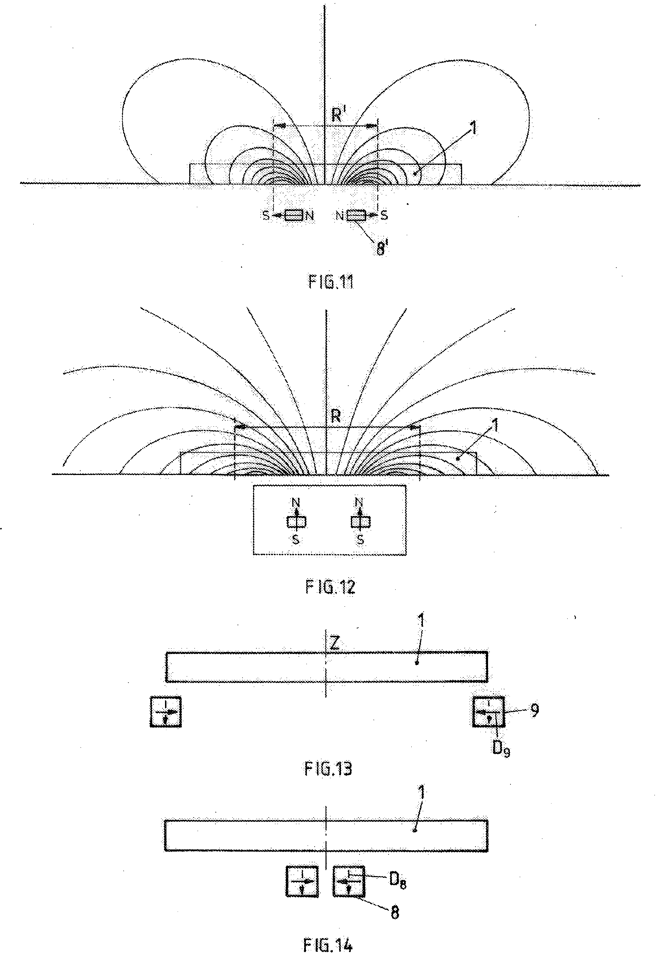

Fig. 11 zeigt das räumliche Magnetfeld eines inneren Magnetssystems 8'. Fig.12 zeigt, vergleichend, ein dem Stand der Technik entsprechendes Feld bei axial gepolten Magneten ähnlicher Geometrie. Hier ist die unterschiedliche Grösse der Bereiche R und R' an der Targetvorderfläche besonders deutlich zu erkennen.

In den Fig. 13 bis 15 sind, schematisch, und in Darstellungen analog zu denjenigen der Fig. 1 bzw. 4 weitere Formen von Magnetsystem-Anordnungen an der erfindungsgemässen Arcquelle dargestellt. Allen gemeinsam ist mindestens ein Magnetsystem, mit z.B. gemäss Fig. 11 mindestens überwiegend radialer Polung.

Gemäss Fig. 13 ist lediglich das äussere Magnetsystem 9 vorgesehen. Es ist, mindesten überwiegend, radial gepolt, d.h. die Dipole D₉ sind mindestens überwiegend parallel zur Targetvorderfläche gerichtet. Es ist aber durchaus möglich, daran auch Magnete mit axialer Polung, d.h. mit Dipolen vorzusehen, die senkrecht zur Tagetvorderfläche stehen, aber mit auf das gesamte Magnetfeld untergeordneter Wirkung.

Gemäss Fig. 14 ist lediglich ein inneres Magnetsystem 8 vorgesehen. Auch dieses ist, mindestens überwiegend, radial gepolt, d.h. mit magnetischen Dipolen D8 mindestens überwiegend parallel zur Targetvorderfläche. Auch hier können , mit untergeordneter Wirkung, ggf. Magnete vorgesehen sein mit axialer Polung, d.h. mit Dipolen, die senkrecht zur Targetvorderfläche stehen.

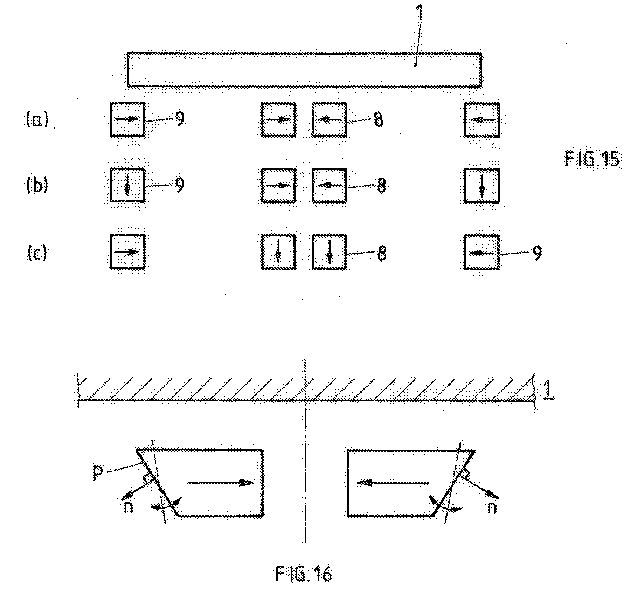

Gemäss Fig. 15(a) ist sowohl ein inneres wie auch ein äusseres Magnetsystem 8 bzw. 9 vorgesehen. Beide Magnetsysteme sind, mindestens überwiegend, radial gepolt, d.h. mit magnetischen Dipolen, welche mindestens überwiegend parallel zur Targetvorderfläche liegen. Dabei können die Dipolrichtungen des inneren und des äusseren Magnetsystems wie dargestellt und wie bevorzugt gleichgerichtet sein, ggf. aber auch invers gerichtet. Gemäss Fig. 15(b), wiederum mit einem inneren und einem äusseren Magnetsystem 8 bzw. 9, ist das innere 8 mindestens überwiegend radial gepolt, während das äussere 9 mindestens überwiegend axial gepolt ist. Umgekehrt ist gemäss Fig. 15(c) das innere Magnetsystem 8 mindestens überwiegend axial gepolt, während das äussere 9 mindestens überwiegend radial gepolt ist.

Im weiteren und mit Blick auf Fig. 11 kann der Magnetfeldverlauf gemäss Fig. 16 durch Einstellung der Ausrichtung der Polflächen P mit ihren Flächennormalen n bezüglich der Targetvorderfläche optimiert werden. Bei den in Fig. 16 von der Targetvorderfläche weggeneigten Polflächen P ergibt sich eine weitere Vergrösserung des Bereiches an der Targetvorderfläche, entlang welchem die radialen Feldkomponenten, d.h. die zur Targetvorderfläche parallelen, die hierzu senkrechten, axialen, überwiegen.

Wie weiter bereits in Fig. 4 dargestellt, kann insbesondere an einem vorgesehenen äusseren Magnetsystem 9 in Form einer geschlossenen Schleife ausgebildet, eine Spulenanordnung 10 vorgesehen sein, mittels welcher der Magnetfeldverlauf über der Targetvorderfläche Target-Material-Form- oder Targetdickenabhängig optimiert werden kann. Ggf. (nicht dargestellt) kann eine solche Spulenanordnung auch Teil des inneren Magnetsystems bilden. Wie in Fig. 4 gestrichelt bei 10' dargestellt, kann eine solche Spulenanordnung mehrere, z.B. zwei Spulen aufweisen, so dass durch Wahl der Spulenstromrichtungen die Feldbeeinflussung noch gezielter realisiert werden kann.

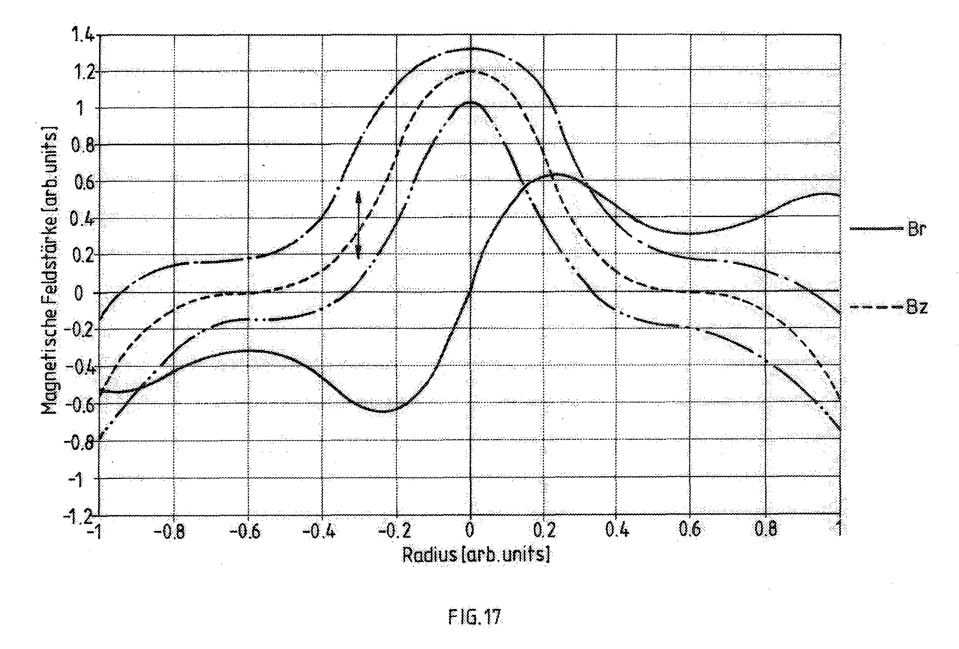

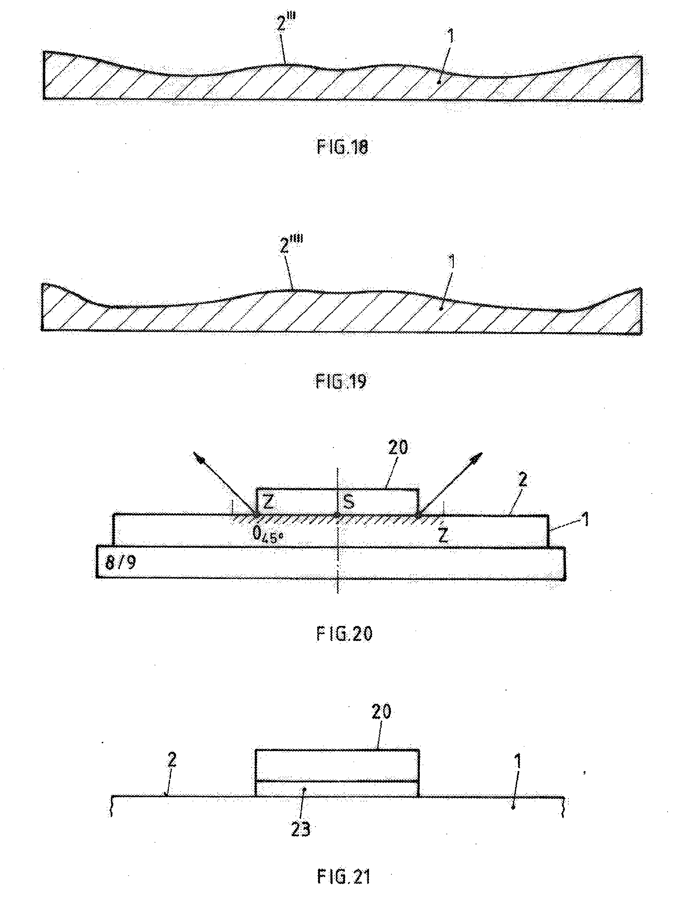

Flexibel, beispielsweise auf unterschiedliche Targetmaterialien bzw. unterschiedliche Targetdicken abstimmbar, ist somit eine erfindungsgemässe Arcquelle in einer Ausführungsform, in der zusätzliches Spulenanordnung 10, 10' vorgesehen sind. Damit lässt sich z.B. in der Ausführung nach Fig. 4 die in Fig. 17 strichliert dargestellte im wesentlichen durch den äusseren axial gepolten Magnetring 9, 10 erzeugte vertikale Magnetfeldkomponente B_{z}, je nach Polung der Spule, zu höheren oder tieferen Werten verschieben (strichpunktierte Linien). Somit kann wie beispielhaft in Fig. 18 bzw. 19 gezeigt das Erosionsprofil 2"', 2"" des Targets 1 weiter optimiert werden. Der Spulenstrom und damit das Magnetfeld werden dabei für das jeweilige Material oder die jeweilige Targetdicke eingestellt. Alternativ kann der Spulenstrom auch dynamisch während der Arcverdampfung angepasst oder beispielsweise periodisch geändert werden.

Gemäss der schematischen Darstellung von Fig. 20 ist in einer weiteren Ausführungsform der erfindungsgemässen Arcquelle innerhalb des zentralen Targetbereiches Z eine Abdeckung 20 vorgesehen. Sie erstreckt sich in einer weiteren Ausführungsform bis zum ersten Ort O_{45°}, wenn vom Flächenschwerkpunkt S an der Targetvorderfläche 2 nach aussen fortgeschritten wird.

Die Abdeckung 20 ist bezüglich der Targetvorderfläche 2 und mithin des Targets 1 elektrisch isoliert.

Die Abdeckung 20 besteht dabei bevorzugterweise aus weichmagnetischem Material, wie z.B. aus Weicheisen oder einer hochtemperaturbeständigen magnetischen Legierung oder aus elektrisch isolierendem Material. Wie in Fig. 21 gezeigt, kann dabei die Abdeckung 20 in einer Schichtstruktur aufgebaut sein, insbesondere mit Schichten der erwähnten Materialien. Wenn, wie in Fig. 21 dargestellt, mindestens die der Targetvorderfläche 2 zugewandte Partie der Abdeckung 20 aus isolierendem Material 23 besteht, entfallen zusätzliche Massnahmen, um die elektrische Isolierung der Abdeckung 20 vom Target 1 sicherzustellen.

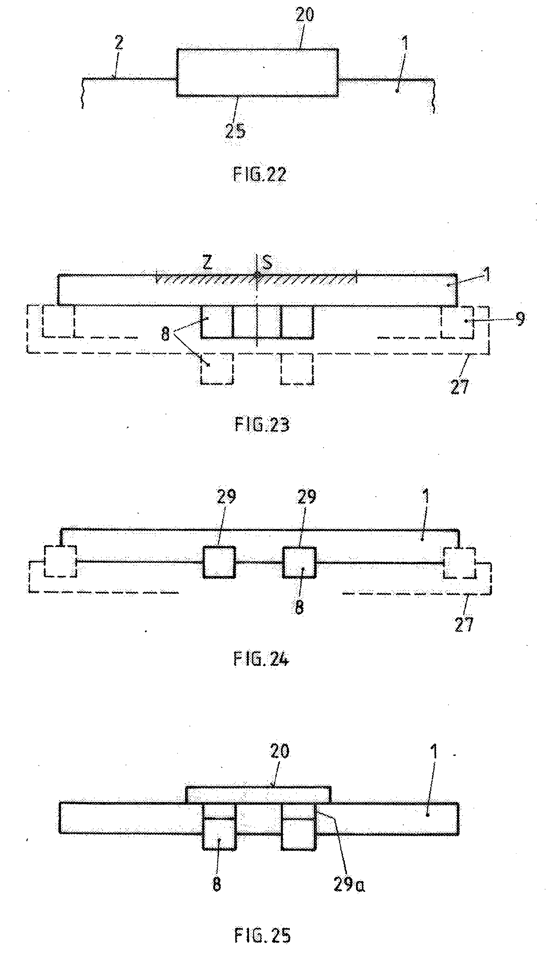

In den Fig. 20 und 21 ist die Abdeckung 20 bündig auf der Targetvorderfläche 2 aufliegend realisiert. In einer weiteren Ausführungsform gemäss Fig. 22 wird die wie beschrieben aufgebaute Abdeckung 20 in die Targetvorderfläche eingesenkt, wie bei 25 schematisch dargestellt, unter Wahrung elektrischer Isolierung. Die Absenkung der Abdeckung 20 beträgt dabei bevorzugterweise zwischen 0,5 mm und 6 mm (beide Grenzen eingeschlossen).

In Fig. 23 ist weiterhin schematisch dargestellt, wie bezüglich des Targets 1 eines oder beide der erfindungsgemäss vorgesehenen Magnetsysteme angeordnet ist bzw. sind. Dabei ist diese Anordnung lediglich anhand des inneren Magnetsystems 8 dargestellt. Es liegt in dieser Ausführungsform an der Rückseite des Targets 1. Ebenso kann an der Targetrückseite in Alleinstellung oder in Kombination mit einem inneren Magnetsystem 8 ein in Fig. 23 gestrichelt dargestelltes äusseres Magnetsystem 9 angeordnet sein. Ist weiter, wie in Fig. 23 ebenfalls gestrichelt eingetragen, und wie üblich, an der Rückseite des Targets 1 eine Kühleinrichtung, wie eine Kühlpatte 27, vorgesehen, so werden die vorgesehenen Magnetsysteme 8 und/oder 9, welche an der Rückseite des Targets 1 angeordnet sind, in entsprechende Aufnahmen an der Kühleinrichtung 27 vorgesehen und dabei vom vorgesehenen Kühlmedium oder von der vorgesehenen Kühlwirkung der Kühleinrichtung 27 mitgekühlt.

Ausgehend von der schematisch in Fig. 23 dargestellten Anordnung sind bei der Anordnung gemäss Fig. 24 die vorgesehenen Magnetsysteme oder mindestens eines, dabei bevorzugt das innere, falls vorgesehen, und wie in Fig. 24 auch dargestellt, in das Target 1 rückseitig eingelassen. Aufgrund der hierzu notwendigen Ausnehmungen 29 an der Rückseite des Targets 1 ergibt sich einerseits eine Einsparung an ggf. teurem Targetmaterial und anderseits ein verbesserter Durchgriff des Magnetfeldes durch das Target hin an dessen Vorderfläche.

Wiederum ist mit 27 die üblicherweise vorgesehene Kühleinrichtung angedeutet.

Werden, wie in Fig. 25 schematisch dargestellt, die Ausnehmungen 29a zur Aufnahme des oder der jeweiligen Magnetsysteme, insbesondere des inneren 8, durch das Target durchgehend ausgebildet, so ergibt sich dadurch einerseits eine weitere Einsparung an ggf. teurem Targetmaterial sowie ein ggf. weiter verbesserter Durchgriff für das Magnetfeld durch das Target. In diesem Fall sind die durchgehenden Ausnehmungen 27a targetvorderflächenseitig mit einer Abdeckung verschlossen, bei derartigen Ausnehmungen, wie dargestellt für das innere Magnetsystem 8, mit einer Abdeckung, wie sie anhand der Fig. 20 bis 22 beschrieben wurde.

Wie weiter in Fig. 23 gestrichelt eingetragen, kann das oder mindestens eines der vorgesehenen Magnetsysteme bei vorhandener Kühleinrichtung 27, insbesondere Kühlplatte, rückseitig der Kühleinrichtung angeordnet sein.

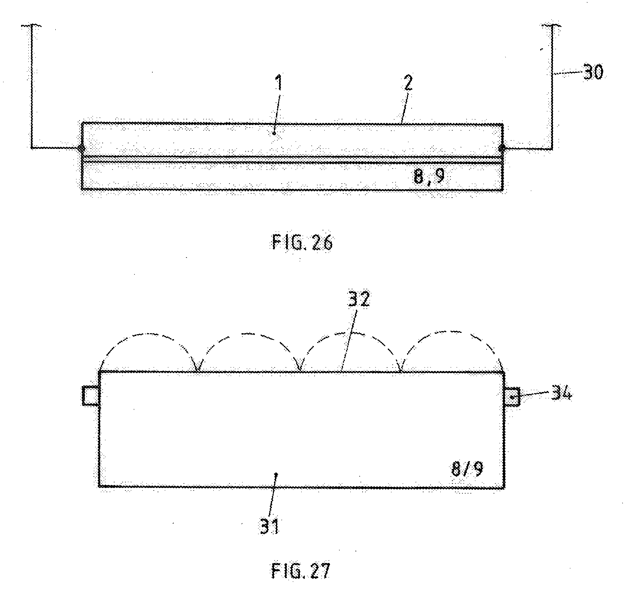

Im weiteren kann es aus Einsatzflexibilitätsgründen äusserst wünschenswert sein, auf das oder auf das mindestens eine vorgesehene Magnetsystem ohne Beeinträchtigung der Vakuumatmosphäre, worin die erfindungsgemässe Arcquelle betrieben wird, Zugriff zu haben. Damit ist es auch möglich, dass für sich erfinderische Magnetsystem für die Arcquelle als Wechselmagnetsystem auszubilden und bezüglich eines Vakuumrezipienten, von aussen, ohne Vakuumbeeinträchtigung leicht auszuwechseln. Dies wird gemäss Fig. 26 grundsätzlich dadurch erreicht, dass die erfindungsgemässe Magnetsystemanordnung 8, 9 mindestens von der Targetvorderfläche 2, die im Einsatz innerhalb des schematisch angedeuteten Vakuumrezipienten 30 situiert ist, vakuummässig getrennt wird.

Eine in der erfindungsgemässen Arcquelle verwendbar Magnetsystemanordnung ist schematisch in einer Ausführungsform in Fig. 27 dargestellt. Sie umfasst in einem Gehäuse 31 nebst ggf. einer Kühleinrichtung (nicht dargestellt) das oder die erfindungsgemäss vorgesehenen Magnetsysteme 8, 9. Das Gehäuse 31 mit der Magnetsystemanordnung definiert eine Austrittsfläche 32 für das gestrichelt dargestelltem Magnetfeld, welche an das Target der erfindungsgemässen Arcquelle angekoppelt wird, wie mittels schematisch dargestellten Schnellverschluss 34. Eine solche Magnetsystemanordnung, insbesondere als Wechselmagnetanordnung ausgebildet, kann, wie erwähnt wurde, eine vorgesehene Kühleinrichtung mitumfassen oder kann an eine vakuumrezipientenseitige Kühleinrichtung angeflanscht werden.

Im Folgenden wird an Hand verschiedener Beispiel die vorteilhafte Wirkung einer erfindungsgemässen Arcquelle gezeigt.

Die Versuche wurden auf einer RCS-Beschichtungsanlage der Firma Balzers mit oktogonalem Querschnitt und ca. 1000 l Beschichtungsvolumen durchgeführt. Der Durchmesser der Beschichtungskammer beträgt 1070 mm, die Höhe 830 mm. Als Arcquelle wurde eine Standardarcquelle der Firma Balzers mit Targetdurchmesser ca. 160mm, d = 6-12mm, Targetwerkstoff: Ti bzw. TiAl) verwendet und bei unterschiedlichsten Betriebsparametern mit einer herkömmlichen und einer erfindungsgemäss vorgesehenen Magnetsystem-Anordnung getestet. Das herkömlichen Magnetsystem wies einen Aufbau gemäss Fig. 1 mit zwei axial gepolten Permanentmagnetringen auf, während das erfindungsgemäss vorgesehene Magnetsystem entsprechend Fig. 4 ausgeführt war. Dabei zeigte sich, dass mit dem erfindungsgemäss vorgesehenen Magnetsystem neben der Verbesserung in der Qualität der beschichteten Oberflächen auch eine wesentliche Verbesserung der Targetausnutzung erzielt wird. So lag die Ausnutzung des Targetmaterials mit bekanntem Magnetsystem je nach Betriebsparametern zwischen 15 und 25 Prozent, die mit der erfindungsgemässen Quelle zwischen 30 und 70 Prozent.

Die Betriebsparameter und Grenzwerte innerhalb deren die jeweiligen Arcquellen getestet wurden sind in Tabelle 1 zusammengestellt.

**Tabelle 1**

| Parameter | Einheit | Bevorzugter Bereich | untere, obere Grenze |
|---|---|---|---|
| Druck | mbar | 10⁻⁴ -4x10⁻¹ | 10⁻⁴ -10⁻¹ |
| Bogenstrom | A | 150-210 | 40-250 |
| Bogenspannung | V | 20-35 | 10-100 |
| Verdampfungsrate Ti | g/min | ca. 0.1-0.3 | bis ca. 0.4 |
| Substratabstand | mm | 200-300 | 100-550 |

In Tabelle 2 sind zusätzlich zwei beispielhafte Betriebsarten zum Abscheiden von TiN bzw. TiAlN angeführt, wobei an die Substrate eine Biasspannung angelegt wurde.

**Tabelle 2**

| | Bias [V ] | Ar [sccm] | N₂ [sccm] | p [mbar] |
|---|---|---|---|---|
| TiN | 100 | 400 | 800 | 3,8 10⁻² |
| TiAlN | 40-150 | 400 | 800 | 3,8 10⁻² |

## Patentansprüche

1. Arcquelle mit einem Target (1), umfassend eine Targetvorderfläche (2) zum Vakuum-Arcverdampfen des Targetmaterials, einer Targetrückseite, einem zentralen Targetbereich (Z) sowie einem Targetrandbereich (A) mit einem Targetrand, einem inneren Magnetsystem (8) im Bereiche des zentralen Targetbereiches (Z) und/oder einem äusseren Magnetsystem (9) im Targetrandbereich, zum Erzeugen eines magnetischen Feldes im Bereich der Targetvorderfläche (2), wobei die vorhandenen besagten Magnetsysteme an oder hinter der Targetrückseite angeordnet sind und Dipole (D₈, D₉) umfasst, wobei die Dipole mindestens eines der Magnetsysteme, mindestens überwiegend parallel zur Targetvorderfläche (2) gerichtet sind und mit Polflächen (P8) der die Dipole (D8) bildenden Magnete, die im wesentlich senkrecht zur Targetvorderfläche (2) stehen oder diese Magnete Polflächen (P) haben, deren Flächennormale (n) von der genannten Vorderfläche (2) wegweisen, wobei dieses Magnetsystem alleine oder in Verbindung mit dem anderen Magnetsystem bewirkt, dass an der Targetvorderfläche die Magnetfeldkomponenten parallel (Br) zur Targetvorderfläche (2) in einem Bereich (R') von zumindest 80% der Targetvorderfläche (2) grösser sind als die zur Targetvorderfläche (2) senkrechten (Bz) Magnetfeldkomponenten.

2. Arcquelle nach Anspruch 1, **dadurch gekennzeichnet, dass** der Bereich zumindest 90% der Targetvorderfläche beträgt.

3. Arcquelle nach einem der Ansprüche 1 oder 2, **dadurch gekennzeichnet, dass** die parallelen Magnetfeldkomponenten (Br) im Bereich (R') 20 - 60 Gauss, bevorzugt 40 - 50 Gauss betragen.

4. Arcquelle nach einem der Ansprüche 1 bis 3, **dadurch gekennzeichnet, dass** im zentralen Targetbereich (Z) eine vom Target elektrisch isolierte Abdeckung (20) vorhanden ist.

5. Arcquelle nach Anspruch 4, **dadurch gekennzeichnet, dass** die Abdeckung den zentralen Targetbereich zumindest bis zu dem Ort abdeckt (O_{45°}), an welchem, vom zentralen Bereich (S) des Targets (1) gegen dessen Rand fortschreitend, die parallelen (Br) und die senkrechten (Bz) Magnetfeldkomponenten erstmals gleich gross sind.

6. Arcquelle nach einem der Ansprüche 4 oder 5, **dadurch gekennzeichnet, dass** die Abdeckung (20) aus einem weichmagnetischen Material und/oder einer hochtemperaturbeständigen magnetischen Legierung und/oder aus elektrisch isolierendem Material besteht.

7. Arcquelle nach einem der Ansprüche 4 bis 6, **dadurch gekennzeichnet, dass** die Abdeckung (20) bündig an der Targetvorderfläche (2) liegt.

8. Arcquelle nach einem der Ansprüche 4 bis 6, **dadurch gekennzeichnet, dass** die Abdeckung (20) in die Targetvorderfläche (2) eingesenkt (25) ist.

9. Arcquelle nach Anspruch 8, **dadurch gekennzeichnet, dass** die Einsenkung 0,5 mm bis 6 mm beträgt.

10. Arcquelle nach einem der Ansprüche 1 bis 9, **dadurch gekennzeichnet, dass** eine Kühlplatte (4, 27) an der Targetrückseite vorhanden ist und das oder mindestens eines der Magnetsysteme (8, 9) an bzw. in Target (1) und/oder Kühlplatte (27) angebracht ist, vorzugsweise, und wenn vorhanden, das innere Magnetsystem (8).

11. Arcquelle nach einem der Ansprüche 1 bis 10, **dadurch gekennzeichnet, dass** das oder mindestens eines der Magnetsysteme mindestens teilweise in einer rückseitigen Ausnehmung (29) im Target (1) angebracht ist, vorzugsweise und wenn vorhanden, das innere Magnetsystem (8).

12. Arcquelle nach Anspruch 11, **dadurch gekennzeichnet, dass** das innere Magnetsystem (8) mindestens teilweise in der Ausnehmung (29) angebracht ist und die Ausnehmung durch das Target hindurch verläuft (29a) und das innere Magnetsystem (8) durch eine Abdeckung (20) gemäss einem der Ansprüche 5 bis 10 abgedeckt ist.

13. Arcquelle nach einem der Ansprüche 1 bis 12, **dadurch gekennzeichnet, dass** das Magnetsystem mit zur Targetvorderfläche mindestens überwiegend parallelen Dipolen Permanentmagnete umfasst, die in einer zur Targetvorderfläche im wesentlichen parallelen Ebene entlang einer geschlossenen Schleife (6, 6') im wesentlichen gleichmässig verteilt sind mit bezüglich der Schleife gleich gerichteten magnetischen Dipolen (D).

14. Arcquelle nach einem der Ansprüche 1 bis 13, **dadurch gekennzeichnet, dass** das oder mindestens eines der Magnetsysteme eine das Targetzentrum umschlingende Spule (10, 10') umfasst.

15. Arcquelle nach einem der Ansprüche 1 bis 14, **dadurch gekennzeichnet, dass** das äussere Magnetsystem (9) vorhanden ist und mindestens mit Teilen den Targetrand überragt.

16. Arcquelle nach einem der Ansprüche 1 bis 15, **dadurch gekennzeichnet, dass** das äussere und das innere Magnetsystem vorhanden sind, mindestens eines davon Dipole mindestens überwiegend parallel, das andere Dipole mindestens überwiegend senkrecht zur Targetvorderfläche umfasst oder beide Magnetsysteme vorhanden sind und beide Dipole mindestens überwiegend parallel zur Targetvorderfläche umfassen, vorzugsweise bezüglich des Targetzentrums gleich gerichtet.

17. Arcquelle nach einem der Ansprüche 1 bis 16, **dadurch gekennzeichnet, dass** beide Magnetsysteme vorhanden sind und das äussere im wesentlichen in einer Ebene mit dem inneren angeordnet ist.

18. Arcquelle nach Anspruch 1-17, **dadurch gekennzeichnet, dass** das oder mindestens das eine Magnetsystem, das an oder hinter der Targetrückseite angeordnet ist, vakuumdicht (30) von der Targetvorderseite (2) getrennt ist.

19. Arcquelle nach einem der Ansprüche 1 bis 18, **dadurch gekennzeichnet, dass** das oder mindestens eines der Magnetsysteme Teil einer Wechselmagnetanordnung (31) ist.

20. Arcquelle nach einem der Ansprüche 1 bis 19, **dadurch gekennzeichnet, dass** das oder das mindestens eine Magnetsystem entlang einer um den Flächenschwerpunkt (S) der Targetvorderfläche (2) umlaufenden, geschlossenen Schleifen (6, 6') aufgebaut ist.

21. Verfahren zur Herstellung arcbeschichteter Werkstücke, durch Verwendung einer Arcquelle nach einem der Ansprüche 1 bis 20.

## Claims

1. Arc source with a target (1), comprising a target front face (2) for vacuum-arc-evaporating target material, a target backside, a central target region (Z) and a target margin region (A) with a target margin, an inner magnet system (8) in the region of the central target region (Z) and/or an outer magnet system (9) in the target margin region, for providing a magnetic field in the region of the target front face (2), wherein the provided of said magnet systems is or are respectively arranged at or behind said target backside and comprises dipoles (D₈, D₉), wherein the dipoles of at least one of the magnet systems are orientated at least predominantly parallel to said target front face (2) and the pole faces (P8) of the magnets for providing the dipoles (D8) are arranged substantially perpendicular to the target front face (2), or these magnets comprise pole faces (P), the surface normals (n) of which are pointing away from said target front face (2), wherein this magnet system alone or in connection with the other magnet system effects at the target front face that the components of the magnet field parallel (Br) to the target front face (2) are larger than the components of the magnet field perpendicular (Bz) to the target front face (2) in a region (R') of at least 80% of the target front face (2).

2. The arc source according to claim 1, **characterized in that** the region is at least 90% of the target front face.

3. The arc source according to claim 1 or 2, **characterized in that** the parallel magnetic field components (Br) in the region (R') are 20 - 60 Gauss, preferably 40 - 50 Gauss.

4. The arc source according to one of claims 1 to 3, further comprising a cover (20) in the central target region (Z) electrically insulated from the target.

5. The arc source according to claim 4, **characterized in that** the cover masks the central target region at least up to the locus (O_{45°}) at which the parallel (Br) and the perpendicular (Bz) magnetic field components are first of equal, when progressing from the central region (S) of the target (1) towards the margin thereof.

6. The arc source according to claim 4 or 5, **characterized in that** the cover (20) is made of at least one of a magnetically soft material; a high-temperature resistant magnetic alloy; an electrically insulating material.

7. The arc source according to one of claims 4 to 6, **characterized in that** the cover (20) is flush in contact on the target front face (2).

8. The arc source according to one of claims 4 to 6, **characterized in that** the cover (20) is counter-sunk (25) into the target front face (2).

9. The arc source according to claim 8, **characterized in that** the counter-sinking is 0,5mm to 6mm.

10. The arc source according to one of claims 1 to 9, further comprising a cooling plate (4, 27) provided at the target backside, and wherein the or at least one of the magnet systems (8, 9), preferably, and if provided, the inner magnet system (8), is disposed on or in, respectively, the target (1) and/or the cooling plate (27).

11. The arc source according to one of claims 1 to 10, **characterized in that** the or at least one of the magnet systems, preferably, and if provided, the inner magnet system (8), is at least in partially disposed in a backside recess (29) in the target (1).

12. The arc source according to claim 11, **characterized in that** the inner magnet system (8) is at least partially disposed in the recess (29), and the recess extends (29a) through the target and the inner magnet system (8) is masked by a cover (20) according to one of claims 5 to 10.

13. The arc source according to one of claims 1 to 12, **characterized in that** the magnet system comprises permanent magnets having dipoles arranged at least predominantly parallel to the target front face, which magnets are substantially uniformly distributed in a plane substantially parallel to the target front face along a closed loop (6, 6') with magnetic dipoles (D) directed identically with respect to the loop.

14. The arc source according to one of claims 1 to 13, **characterized in that** the or at least one of the magnet systems comprises a coil (10, 10') looped around the target center.

15. The arc source according to one of claims 1 to 14, comprising the outer magnet system (9), wherein at least portions of it project beyond the target margin.

16. The arc source according to one of claims 1 to 15, comprising the outer and inner magnet systems, wherein at least one thereof comprises dipoles arranged at least predominantly parallel to the target front face, wherein the other thereof comprises dipoles arranged at least predominantly perpendicular to the target front face, or comprising both magnet systems, and wherein both magnet systems comprise dipoles arranged at least predominantly parallel to the target front face, preferably identically directed with respect to the target center.

17. The arc source according to one of claims 1 to 16, comprising both magnet systems, and wherein the outer thereof is substantially disposed in one plane with the inner thereof.

18. The arc source according to one of claims 1 to 17, **characterized in that** the or at least one of the magnet systems disposed on or behind the target backside, is separated vacuum-tight (30) from the target front face (2).

19. The arc source according to one of claims 1 to 18, **characterized in that** the or at least one of the magnet systems is part of a changeover magnet configuration (31).

20. The arc source according to one of claims 1 to 19, **characterized in that** the or at least one of the magnet systems is structured along a closed loop (6, 6') encircling the area center point (S) of the target front face (2).

21. A method for the production of arc-coated workpieces by using an arc source according to one of claims 1 to 20.

## Revendications

1. Source d'arc avec une cible (1) comprenant une surface avant de cible (2) pour l'évaporation par arc sous vide du matériau de cible, avec une face arrière de cible, avec une zone centrale de cible (Z) et avec une zone de bord de cible (A) pourvue d'un bord de cible, avec un système magnétique intérieur (8) dans la zone de la zone centrale de cible (Z) et/ou un système magnétique extérieur (9) dans la zone de bord de cible, pour produire un champ magnétique dans la zone de la surface avant de cible (2), étant précisé que les systèmes magnétiques prévus sont disposés sur ou derrière la face arrière de cible et comprennent des dipôles (D₈, D₉), étant précisé que les dipôles de l'un au moins des systèmes magnétiques sont orientés au moins en grande partie parallèlement à la surface avant de cible (2), et avec des faces polaires (P8) des aimants formant les dipôles (D8) qui sont globalement perpendiculaires à la surface avant de cible (2) ou ces aimants ont des faces polaires (P) dont la normale de surface (n) est dirigée à l'opposé de ladite surface avant (2), étant précisé que ce système magnétique, seul ou combiné avec l'autre système magnétique, fait que sur la surface avant de cible les composantes de champ magnétique parallèles (Br) à la surface avant de cible (2) dans une zone (R') représentant au moins 80 % de ladite surface avant (2) sont plus grandes que les composantes de champ magnétique perpendiculaires (Bz) à la surface avant (2).

2. Source d'arc selon la revendication 1, **caractérisée en ce que** ladite zone représente au moins 90 % de la surface avant de cible.

3. Source d'arc selon l'une des revendications 1 ou 2, **caractérisée en ce que** les composantes de champ magnétique parallèles (Br) dans la zone (R') sont de 20-60 gauss, de préférence de 40-50 gauss.

4. Source d'arc selon l'une des revendications 1 à 3, **caractérisée en ce qu'**il est prévu dans la zone centrale de cible (Z) un recouvrement (20) isolé électriquement de la cible.

5. Source d'arc selon la revendication 4, **caractérisée en ce que** le recouvrement recouvre la zone centrale de cible au moins jusqu'à l'endroit (O_{45°}) où, de la zone centrale (S) de la cible (1) vers le bord de celle-ci, les composantes de champ magnétique parallèles (Br) et perpendiculaires (Bz) sont pour la première fois aussi grandes.

6. Source d'arc selon l'une des revendications 4 ou 5, **caractérisée en ce que** le recouvrement (20) se compose d'un matériau magnétique doux et/ou d'un alliage magnétique résistant aux températures élevées et/ou d'un matériau isolant électriquement.

7. Source d'arc selon l'une des revendications 4 à 6, **caractérisée en ce que** le recouvrement (20) se trouve au ras de la surface avant de cible (2).

8. Source d'arc selon l'une des revendications 4 à 6, **caractérisée en ce que** le recouvrement (20) est encastré dans la surface avant de cible (2).

9. Source d'arc selon la revendication 8, **caractérisée en ce que** l'encastrement est de 0,5 mm à 6 mm.

10. Source d'arc selon l'une des revendications 1 à 9, **caractérisée en ce qu'**il est prévu une plaque de refroidissement (4, 27) sur la face arrière de cible, et le système magnétique ou l'un au moins des systèmes magnétiques (8, 9) est monté sur ou dans la cible (1) et/ou la plaque de refroidissement, de préférence, et s'il est prévu, le système magnétique intérieur (8).

11. Source d'arc selon l'une des revendications 1 à 10, **caractérisée en ce que** le système magnétique ou l'un au moins des systèmes magnétiques est monté dans la cible (1) au moins en partie dans un creux (29) situé côté arrière, de préférence et s'il est prévu, le système magnétique intérieur (8).

12. Source d'arc selon la revendication 11, **caractérisée en ce que** le système magnétique intérieur (8) est monté au moins en partie dans le creux (29), et le creux traverse (29a) la cible, et le système magnétique intérieur (8) est recouvert par un recouvrement (20) selon l'une des revendications 5 à 10.

13. Source d'arc selon l'une des revendications 1 à 12, **caractérisée en ce que** le système magnétique pourvu de dipôles au moins en grande partie parallèles à la surface avant de cible comprend des aimants permanents qui sont répartis globalement uniformément, dans un plan globalement parallèle à la surface avant de cible, le long d'une boucle fermée (6, 6'), avec des dipôles magnétiques (D) à orientation identique par rapport à la boucle.

14. Source d'arc selon l'une des revendications 1 à 13, **caractérisée en ce que** le système magnétique ou l'un au moins des systèmes magnétiques comprend une bobine (10, 10') qui entoure le centre de la cible.

15. Source d'arc selon l'une des revendications 1 à 14, **caractérisée en ce que** le système magnétique extérieur (9) est prévu et, au moins avec des parties, dépasse du bord de cible.

16. Source d'arc selon l'une des revendications 1 à 15, **caractérisée en ce que** les systèmes magnétiques extérieur et intérieur sont prévus, l'un au moins comprend des dipôles au moins en grande partie parallèles tandis que l'autre comprend des dipôles au moins en grande partie perpendiculaires à la surface avant de cible, ou les deux systèmes magnétiques sont prévus et comprennent tous les deux des dipôles au moins en grande partie parallèles à la surface avant de cible, de préférence avec la même orientation par rapport au centre de la cible.

17. Source d'arc selon l'une des revendications 1 à 16, **caractérisée en ce que** les deux systèmes magnétiques sont prévus, et le système magnétique extérieur est disposé globalement dans le même plan que le système magnétique intérieur.

18. Source d'arc selon l'une des revendications 1 à 17, **caractérisée en ce que** le système magnétique ou l'un au moins des systèmes magnétiques qui est disposé sur ou derrière la face arrière de cible est séparé de la face avant de cible (2) de manière étanche au vide (30).

19. Source d'arc selon l'une des revendications 1 à 18, **caractérisée en ce que** le système magnétique ou l'un au moins des systèmes magnétiques fait partie d'un dispositif magnétique alternatif (31).

20. Source d'arc selon l'une des revendications 1 à 19, **caractérisée en ce que** le système magnétique ou l'un au moins des systèmes magnétiques est construit le long d'une boucle fermée (6, 6') qui fait le tour du centre de gravité (S) de la surface avant de cible (2).

21. Procédé pour la fabrication de pièces revêtues par arc, **caractérisé par** l'utilisation d'une source d'arc selon l'une des revendications 1 à 20.
